**Europäisches Patentamt**

**European Patent Office**

**Office européen des brevets**

(19)

(11) Veröffentlichungsnummer: **0 032 222**
**B1**

(12)

# EUROPÄISCHE PATENTSCHRIFT

(45) Veröffentlichungstag der Patentschrift:
**25.04.84**

(21) Anmeldenummer: **80107994.8**

(22) Anmeldetag: **17.12.80**

(51) Int. Cl.³: **G 01 R 31/28**

(54) **Prüfeinrichtung.**

(30) Priorität: **21.12.79 DE 2951929**

(43) Veröffentlichungstag der Anmeldung:
**22.07.81 Patentblatt 81/29**

(45) Bekanntmachung des Hinweises auf die Patenterteilung:
**25.04.84 Patentblatt 84/17**

(84) Benannte Vertragsstaaten:
**FR GB NL**

(56) Entgegenhaltungen:
**DE - A - 2 213 368**
**DE - A - 2 451 094**
**DE - A - 2 520 340**
**DE - A - 2 528 875**
**DE - B - 2 233 612**
**DE - B - 2 346 617**

(73) Patentinhaber: **SIEMENS AKTIENGESELLSCHAFT,
Berlin und München Wittelsbacherplatz 2,
D-8000 München 2 (DE)**

(72) Erfinder: **Welzhofer, Klaus, Ruffini-Allee 30,
D-8032 Gräfelfing (DE)**

# 0 032 222

## Prüfeinrichtung

Die Erfindung bezieht sich auf eine Prüfeinrichtung für ein automatisches Prüfsystem zur Funktionsprüfung von integrierten Schaltkreisen unterschiedlicher Schaltkreisfamilien.

Jedes Prüfsystem muß die zur Prüfung erforderlichen statischen und dynamischen Pegel intern erzeugen und dem Prüfling anbieten. Soll nun ein Prüfsystem flexibel sein, so muß es möglichst viele Pegel erzeugen, um damit gleichzeitig verschiedene Schaltkreisfamilien ansteuern zu können. Bisher wird dies dadurch erreicht, daß auf einer »Anschaltebaugruppe« die entsprechenden Gatterbausteine aus den zu prüfenden Logikfamilen aufgebaut sind und mittels Relais jeweils angeschaltet werden. Diese Bausteine sind nicht kurzschlußfest, was bei fehlerbehafteten Prüflingen öfters zu Ausfällen führt.

Aus der DE-B-2 233 612 ist eine Endstufe für einen Prüfsignalgeber mit einer einstellbaren Spannungsquelle bekannt, die praktisch kurzschlußfest und rückspeisungsfest ist.

Aufgabe der vorliegenden Erfindung ist es, eine Prüfeinrichtung zu schaffen, die zur Prüfung von Schaltkreisen unterschiedlicher Schaltkreisfamilien auf den jeweils benötigten Pegel vorprogrammierbar ist und die Mittel vorsieht, die verhindern, daß Fehler im Prüfling die Prüfeinrichtung zerstören.

Die erfindungsgemäße Lösung dieser Aufgabe ist in Anspruch 1 definiert.

Durch diese Maßnahme erhält man eine Prüfeinrichtung, bei der die Ansteuerbarkeit von unterschiedlichen Schaltkreisfamilien mit der gleichen Prüfeinrichtung möglich ist, wodurch eine Erhöhung der Prüfschärfe erreicht wird.

Weiterbildungen der Erfindung sind Gegenstand der abhängigen Ansprüche.

Die Konstantstromquelle kann dabei aus einem ersten Transistor in Emitterschaltung und einem diesem nachgeschalteten zweiten Transistor in Basisschaltung bestehen.

Durch diese Konstantstromquelle wird der auf Null Volt bezogene TTL-Eingangspegel auf einen Stromhub definierter Größe, der für die Ansteuerung der Endstufe des Senders ausreicht, umgeformt.

Die Endstufe besteht aus einem dritten und einem vierten Transistor, die als Emitterfolger geschaltet sind, in dessen Ausgangskreis ein in Abhängigkeit vom Ausgangspegel gesteuerter fünfter Transistor, der als die gesteuerte Last wirkt, liegt, wobei die Basis dieses fünften Transistors an dem Verbindungspunkt des Kollektors des dritten Transistors mit dessen Kollektorwiderstand geführt ist.

Dadurch erhält man eine Endstufe, die im Vierquadrantenbetrieb betrieben werden kann, d. h. sie kann sowohl Leistung abgeben als auch in bestimmten Grenzen Leistung aufnehmen, ohne daß dabei die Konstanz des Ausgangspegels wesentlich verändert wird.

Die Prüfeinrichtung kann außerdem derart ausgebildet sein, daß die Programmierschaltung einen sechsten und einen siebenten Transistor aufweist, die kollektorseitig jeweils über eine erste bzw. zweite Reihenschaltung aus einer ersten Diode und einem ersten Ohmschen Widerstand bzw. einer zweiten Diode und einem zweiten Ohmschen Widerstand mit dem Eingang der Endstufe und dem Ausgang der Konstantstromquelle und emitterseitig mit der ersten Klemme der Versorgungsspannungsquelle verbunden sind, daß parallel zu den Reihenschaltungen und dem sechsten bzw. siebenten Transistor ein dritter Ohmscher Widerstand geschaltet ist, der so dimensioniert ist, daß im Sperrzustand des sechsten und siebenten Transistors am Ausgang der Endstufe MOS-»logisch 1« Pegel liegt und daß ein achter Transistor über eine erste Zenerdiode emitterseitig mit dem Eingang der Endstufe und dem Ausgang der Konstantstromquelle und kollektorseitig mit der zweiten Klemme der Versorgungsspannungsquelle verbunden ist, und daß die Basis des sechsten bzw. siebenten Transistors über zweite bzw. dritte Zenerdioden mit einem TTL-Logikpegel ansteuerbar sind, und die Basis des achten Transistors an den Abgriff eines ersten Spannungsverteilers mit zwei Widerständen, der zwischen der zweiten Klemme und Masse liegt, geführt ist und daß zwischen dem Abgriff dieses ersten Spannungsteilers und dem Kollektor des siebenten Transistors eine dritte Reihenschaltung aus einem vierten Ohmschen Widerstand und einer dritten Diode angeordnet ist und daß die Widerstände der ersten und zweiten Reihenschaltung so dimensioniert sind, daß bei Sperrzustand jeweils des sechsten bzw. siebenten Transistors TTL-»log 1« Pegel bzw. ECL-»log 1« Pegel am Ausgang der Endstufe ansteht.

Dadurch wird die Erzeugung gewünschter Ausgangspegel in einfacher Weise möglich.

Die Eingänge der Programmierschaltung können über einen neunten bzw. zehnten Transistor in Kollektorschaltung angesteuert sein, an deren Eingängen jeweils die zur Programmierung erforderlichen TTL-Logikpegel anlegbar sind. Dadurch erhält man eine rückwirkungsfreie Ansteuerung.

Zur Kompensation des Temperaturgangs der Basisemitterstrecke des achten Transistors läßt sich zwischen den beiden Spannungsteilerwiderständen des ersten Spannungsteilers eine vierte Diode anordnen.

Zur Verringerung der Basisansteuerung des fünften Transistors bei gewünschtem ECL-Ausgangspegel ist es vorteilhaft, daß die Basis des als gesteuerte Last wirkenden fünften Transistors der Endstufe über einen fünften Ohmschen Widerstand und eine fünfte Diode mit dem Kollektor des siebenten Transistors der Programmierschaltung verbunden ist.

Bildet man die Prüfeinrichtung derart aus, daß zwischen dem Emitter des vierten Transistors der Endstufe und dem als gesteuerte Last geschalteten fünften Transistor eine vierte und fünfte Zenerdiode liegen, an deren Verbindungspunkt die Ausgangsspannung der Endstufe abgegriffen wird, so erreicht man einen Schutz bei positiven Überspannungen bei ausgangsseitiger Einspeisung für den vierten Transistor.

Das Überschreiten der zulässigen Verlustleistung des fünften Transistors bei Einspeisung positiver Überspannung am Ausgang wird dadurch vermieden, daß der dritte und vierte Transistor über eine sechste Zenerdiode miteinander verbunden sind, und daß der Emitter des dritten Transistors mit der Basis eines zusätzlichen elften Transistors verbunden ist, dessen Kollektor über einen sechsten Ohmschen Widerstand an die erste Klemme und dessen Emitter über einen siebenten Ohmschen Widerstand an den Kollektor des fünften Transistors geführt ist, daß die Basis eines zwölften Transistors, dessen Emitter und Kollektor jeweils an einer der Klemmen der Versorgungsspannungsquelle liegen, mit dem Kollektor des elften Transistors verbunden ist und daß der Kollektor des zwölften Transistors außerdem über eine siebte Zenerdiode an die Basis des vierten Transistors geführt ist.

Eine Sperrung der Endstufenhalbleiter erreicht man dadurch, daß der Kollektor eines dreizehnten Transistors über einen achten Ohmschen Widerstand an die Basis des zwölften Transistors geführt ist, daß die Basis des dreizehnten Transistors als dritter Programmiereingang mit einem statischen TTL-Pegel beaufschlagbar ist, und daß die Kollektoren des zwölften Transistors und des dritten Transistors über eine achte Zenerdiode miteinander verbunden sind.

Die Vergleichschaltung des Empfängers ist eine aus einem vierzehnten und fünfzehnten Transistor bestehende Differenzverstärkerschaltung, an deren einem Eingang der Ausgang des Senders und an deren anderem Eingang die Referenzspannung liegt. Schaltet man den Kollektorwiderständen des vierzehnten und fünfzehnten Transistors Schottky-Dioden parallel, so wird dadurch die Stromamplitude begrenzt. Das hat den Vorteil, daß der Verstärkungsfaktor bei ausreichend hochohmig dimensionierten Kollektorwiderständen groß ist und der sogenannte Miller-Effekt trotzdem klein gehalten werden kann.

Zur Einstellung des DC-Arbeitspunktes für den Speicherbaustein ist es vorteilhaft, daß die Kollektorwiderstände des vierzehnten und fünfzehnten Transistors über einen gemeinsamen Widerstand an der ersten Klemme liegen. Um die Eingänge des Speichers vor Überspannung zu schützen, wird den Kollektorwiderständen des vierzehnten und fünfzehnten Transistors jeweils eine neunte und zehnte Zenerdiode in Reihe geschaltet.

Die in den Emitterzweigen des vierzehnten und fünfzehnten Transistors der Vergleichsschaltung liegenden sechsten und siebten Dioden verhindern eine Zerstörung des vierzehnten und fünfzehnten Transistors der Vergleichsschaltung bei Durchbruch der Basisemitterstrecke dieser Transistoren in Sperr-Richtung.

Der Speicher des Empfängers kann vorteilhaft aus einem taktgesteuerten D-Flipflop bestehen, dem als Abtastspannung ein logischer ECL-Pegel zuführbar ist.

Bei extrem negativen Überspannungen am Ausgang des Senders läßt sich der vierte Transistor dadurch schützen, daß die Emitter des vierzehnten und fünfzehnten Transistors über einen neunten Ohmschen Widerstand, eine elfte und zwölfte Zenerdiode und einen zehnten Ohmschen Widerstand mit der zweiten Klemme verbunden sind.

Legt man parallel zu den Elementen im gemeinsamen Emitterkreis des vierzehnten und fünfzehnten Transistors einen sechzehnten Transistor, dessen Basis mit dem Abgriff eines zweiten Spannungsteilers verbunden ist, so erhält man eine Konstantstromquelle für die Vergleichsschaltung, wodurch ein großer Gleichtakt-Bereich erreicht wird. Zur Kompensierung des Temperaturgangs der Basisemitterstrecke des sechzehnten Transistors ist es vorteilhaft, daß im Kollektorkreis des vierten Transistors die Kollektor-Emitterstrecke eines im normalen Betriebsfall leitenden siebzehnten Transistors liegt, dessen Basis über den zweiten Spannungsteiler an Masse geführt ist, daß zwischen Abgriff des zweiten Spannungsteilers und der zweiten Klemme die Kollektor-Emitterstrecke eines achtzehnten Transistors liegt, dessen Basis an den Verbindungspunkt des zehnten Ohmschen Widerstandes mit der elften Zenerdiode geführt ist.

Einen Schutz des vierten Transistors vor Überstrom erhält man dann, wenn zwischen dem Kollektor des vierten Transistors der Endstufe und dem Kollektor des siebzehnten Transistors ein elfter Ohmscher Widerstand eingeschaltet ist.

Um den Einsatzpunkt der Strombegrenzung bei nicht abgeschlossenen Leitungen umschaltbar zu machen, läßt sich die Prüfeinrichtung auch derart ausbilden, daß zwischen dem elften Ohmschen Widerstand und dem Kollektor des siebzehnten Transistors die Kollektor-Emitter-Strecke eines neunzehnten Transistors liegt, dessen Basis über eine dreizehnte Zenerdiode und den Emitter eines zwanzigsten Transistors angesteuert wird und dessen Basis einen vierten Programmiereingang bildet, an dem ebenfalls ein logisches TTL-Signal anlegbar ist.

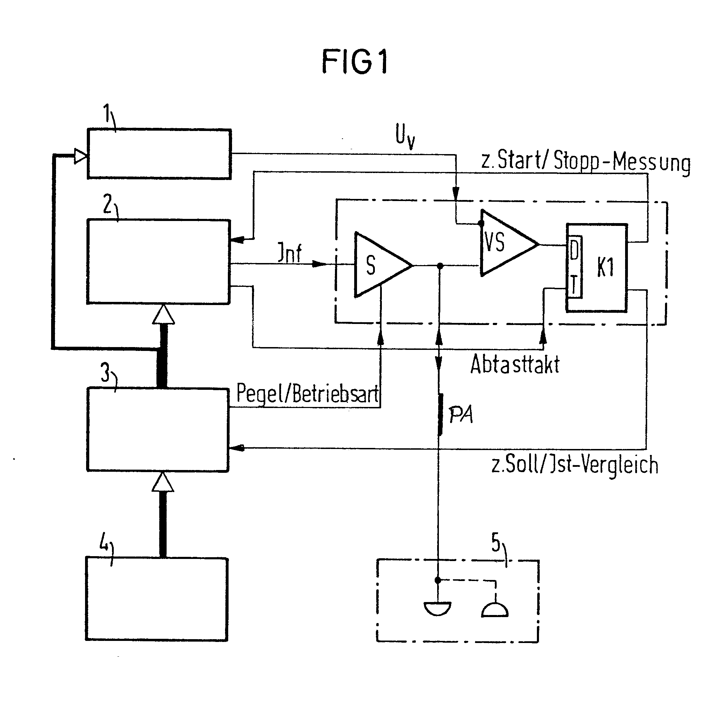

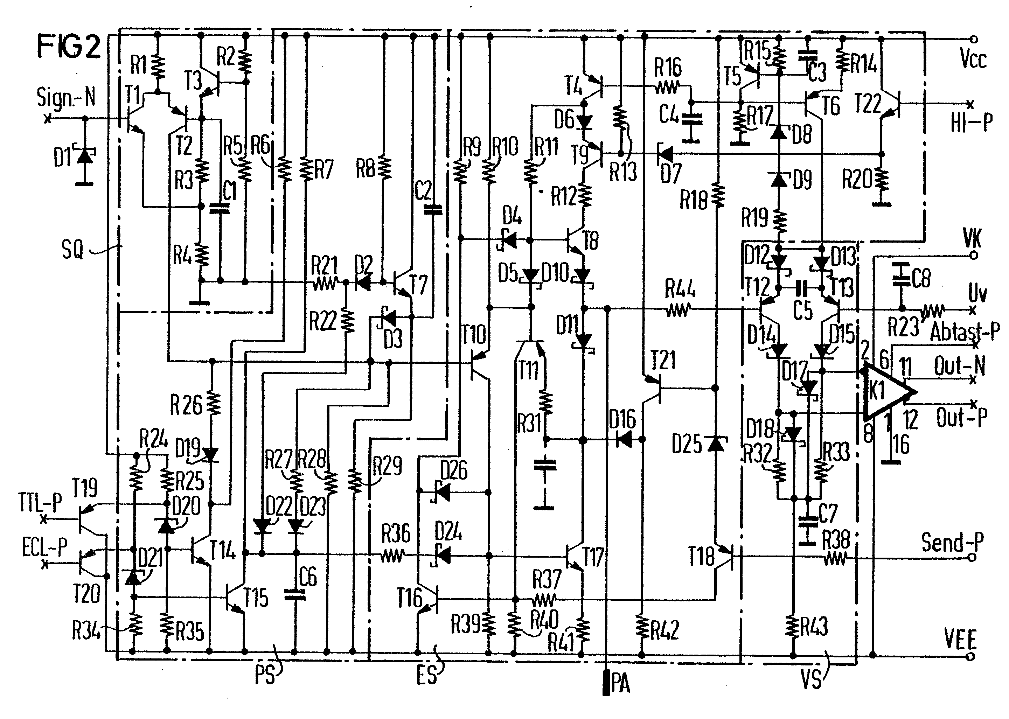

Anhand des Blockschaltbildes nach Fig. 1 sowie des Ausführungsbeispiels nach Fig. 2 wird die Erfindung näher erläutert.

Fig. 1 zeigt schematisch den Einsatz einer Prüfeinrichtung nach der Erfindung in einem Prüfautomaten.

Innerhalb des strichliert gezeichneten Teiles befindet sich die erfindungsgemäße Prüfeinrichtung,

3

die aus dem Sender S sowie dem die Vergleichsschaltung VS und den Speicher K1 umfassenden Empfänger besteht. Am Ausgang des Senders, der gleichzeitig Eingang des Empfängers ist, wird eine Leitung angeschaltet, die zum Prüfstift des jeweiligen Prüflings 5 im Prüfautomaten führt. Die Datenverarbeitungsanlage 4 wirkt auf die Ablaufsteuerung 3 ein und diese wiederum sowohl auf das Zeitsteuerungs- und Meßsystem 2 sowie den Spannungsgeber 1. Der Spannungsgeber 1 liefert die Vergleichsspannung UV für die Vergleichsschaltung VS. Der eine Ausgang des Speichers ist außerdem mit dem Zeitsteuerungs- und Meßsystem verbunden und bewirkt bei jeder Messung den entsprechenden Start und den anschließenden Stop. Gleichzeitig wird am zweiten Ausgang des Speichers ein Soll-Ist-Vergleichswert der Ablaufsteuerung zugeführt, wobei die Ablaufsteuerung gestoppt wird, wenn der Soll-Ist-Vergleich aufzeigt, daß ein Fehler im Prüfling vorliegt. Gleichzeitig wird von der Ablaufsteuerung auch die Programmierung des Senders für die jeweils gewünschte Betriebsart bzw. den gewünschten Ausgangspegel vorgenommen. Das Eingangssignal des Senders erhält dieser wiederum vom Zeitsteuerungs- und Meßsystem.

Die detaillierte Schaltung der Prüfeinrichtung ist in Fig. 2 dargestellt.

Der Sender stellt im Prinzip einen Impulsformer dar, d. h. das über den Eingang Sign-N ankommende TTL-Signal wird zeitlich unverändert, jedoch durch die Programmiereingänge TTL-P bzw. ECL-P in seinen Amplituden-Eckwerten (entsprechend ECL, TTL und MOS) jeweils veränderbar an den Ausgang PA durchgeschaltet.

Transistor $T_1$ arbeitet als getastete Konstantstromquelle. Seine Aufgabe besteht darin, den 0V-bezogenen TTL-Eingangspegel in einen Stromhub definierter Größe umzuformen, der dann am Widerstand $R_1$ einen genügend großen Spannungsabfall von $V_{cc}$ subtrahiert, so daß Transistor $T_2$ — bei Ansteuerung der Basis von $T_1$ mit TTL logisch »1« ( +3,5V)-sicher sperrt. Für den Kollektorstrom von $T_1$ gilt somit (unter Vernachlässigung des Stromes durch $R_3$):

$$I_c T_1 = \frac{|TTL - »1«| - |U_{BE}T_1|}{R_4} \left(1 - \frac{1}{B_T 1}\right)$$

$B_T 1$ = Stromverstärkung von $T_1$

Am Emitter von $T_2$ liegt dann die Spannung:

$$U_E T_2 = V_{cc} - (I_c T_1 \cdot R_1)$$

Transistor $T_2$ arbeitet in Basisschaltung; er bildet zusammen mit $R_1$ eine am Emitter gesteuerte Konstantstromquelle. Dies bietet den Vorteil, daß man mit kleinen Steuerspannungshüben auskommt, wodurch die parasitären Transistorkapazitäten

$$C_{CBO}T_1 C_{CE}T_1 \text{ bzw. } C_{CBO}T2$$

nicht so weit umgeladen werden müssen, und außerdem die parasitäre Gegenkopplung über die Kollektor-Basiskapazität von $T_2$ (Miller-Effekt) durch den niederohmigen Arbeitspunkt an der Basis von $T_2$ weitgehend wirkungslos bleibt, was zu schnellerem Schaltverhalten führt.

Transistor $T_3$ arbeitet einerseits als Konstantspannungsquelle, indem er die Basisvorspannung für $T_2$ bildet, andererseits wirkt die $U_{BE}T_3$ kompensierend dem Temperaturgang der $U_{BE}$ von Transistor $T_2$ entgegen.

Dadurch, daß der Emitter von $T_1$ mit dem Spannungsteilermittelpunkt $R_3$, $R_4$ verbunden ist, ergibt sich für das Eingangssignal an der Basis von $T_1$ eine digitale Schaltschwelle, die — durch entsprechende Dimensionierung von $R_3$ und $R_4$ — bei der Hälfte des Eingangs-TTL-Pegels ($\hat{=}$ +1,5 V) liegt.

Die Schottky-Diode $D_1$ wirkt als Leitungsabschluß, indem sie negative Überschwinger des Eingangsimpulses gegen 0V kurzschließt.

Wie bereits erwähnt, bildet die Transistorstufe $T_2$ ebenfalls eine getastete Konstantstromquelle, deren Kollektorstrom

$$I_c T_2 = \frac{|U_{CE}T_3| - |U_{BE}T_2|}{R_1} \left(1 - \frac{1}{B_T 2}\right)$$

$B_T 2$ = Stromverstärkung von $T_2$

in Abhängigkeit der statischen Logikpegel an den Programmiereingängen TTL-P bzw. ECL-P, durch einen der dadurch — über $T_{14}$ oder $T_{15}$ — angeschalteten Widerstände $R_{26}$ oder $R_{27}$ und durch $R_{28}$ fließt.

Hierdurch werden die Amplituden-Eckwerte für den jeweiligen logisch »1«-Pegel des Ausgangsimpulses gebildet.

Es sei angenommen, daß beide Programmiereingänge TTL-P und ECL-P den TTL-logisch »0«-Pegel ( +0,4 V) führen, dann sind die beiden Zenerdioden $D_{20}$ und $D_{21}$ gesperrt. Dies bewirkt, daß die Basen

4

von $T_{14}$ und $T_{15}$ über $R_{34}$ bzw. $R_{35}$ auf Emitterpotential liegen, wodurch $T_{14}$ und $T_{15}$ sperren. Der Kollektorstrom von Transistor $T_2$ fließt in diesem Fall voll durch Widerstand $R_{28}$ nach $V_{EE}$ ab. Die Spannung an der Basis von $T_{10}$ ist demnach:

$$U_B T_{10} = V_{EE} + /I_C T_2/ \cdot R_{28}$$

Diese Spannung bildet am Ausgang die logische »1« für den MOS-Pegel ( =positivster Ausgangswert).

Wechselt nun beispielsweise der statische logisch »0«-Pegel am Programmiereingang TTL-P nach logisch »1« ( $\hat{=}$ +3,5 V), so zündet die Zenerdiode $D_{20}$, und es fließt der Strom

$$I_B T_{14} = \frac{|V_{EE} + V_{cc} - U_{BE} T_{14} - U_Z D_{20}|}{R_{25}}$$

in die Basis von $T_{14}$.

Transistor $T_{14}$ und Diode $D_{19}$ sind somit leitend und es bildet sich an der Basis $T_{10}$ die Spannung:

$$U_B T_{10} = V_{EE} + R_{28} \frac{|I_c T_2 \cdot R_{26} + U_D 19 + U_{CE} T_{14}|}{R_{26} + R_{28}} .$$

Diese Spannung definiert am Ausgang den logisch »1«-Pegel für TTL.

Wird dagegen der Eingang ECL-P durch Anlegen von statisch TTL-logisch»1«-aktiviert, so zündet Zenerdiode $D_{21}$, und der oben beschriebene Vorgang wiederholt sich über die Bauelemente $T_{15}$, $D_{23}$ und $R_{27}$. Damit ist der logisch »1«-Pegel für ECL am Ausgang definiert. Die Bauteile $D_2$ und $T_7$ bilden eine Konstantspannungsquelle (Emitterfolger $T_7$), die über den Spannungsteiler $R_8$, $R_{21}$, $R_{22}$ durch Transistor $T_{15}$ umprogrammiert werden kann. Die Schottky-Diode $D_3$ wirkt hierbei als Amplitudenbegrenzer; sie bestimmt — bezogen auf das Emitterpotential von Transistor $T_7$ — den jeweiligen logisch »0«-Pegel (bei gesperrtem Transistor $T_2$) des Ausgangsimpulses.

Da der logisch »0«-Pegel bei MOS und TTL-Signalen ca. 0 Volt entspricht, muß die Basis von $T_7$ die Spannung

$$U_B T_7 = U_D 3 + U_{BE} T_7$$

führen. Diese Spannung wird über den Spannungsteiler $R_8$, $D_2$, $R_{21}$ erzeugt; Transistor $T_{15}$ ist in diesem Fall abgeschaltet, so daß durch $R_{22}$ kein Strom fließt. Nur bei Einschalten des ECL-Ausgangspegels — dessen logisch »0«-Potential liegt bei $-1,8$ V — wird Transistor $T_{15}$ leitend, und es stellt sich durch $R_{22}$ und $D_{22}$ ein Strom ein, der das Basispotential von $T_7$ entsprechend ins Negative verschiebt. Die Diode $D_2$ kompensiert den Temperaturgang der $U_{BE}$ von Transistor $T_7$.

Die Halbleiter $T_{10}$, $T_8$ und $T_{17}$ bilden die Sender-Endstufe, wobei die Transistoren $T_{10}$ und $T_8$ in Kollektorschaltung (Emitterfolgerstufen) betrieben werden, also keine Spannungsverstärkung bewirken.

Transistor $T_{17}$ wirkt als dynamisch veränderliche Konstantstromlast für $T_8$. Dadurch stellt sich gesteuert über den Kollektorzweig von $T_{10}$ — eine für $T_{17}$ pegelabhängige Basissteuerspannung ein, die letztlich den Querstrom durch die Endstufe variiert. Durch diese Maßnahme ergibt sich bezüglich der Sender-Endstufe ein bidirektionales Stromverhalten, d. h. die Endstufe kann sowohl Strom an einen Verbraucher abgeben, sowie auch Strom aufnehmen. Die Spannungsänderung an der Basis von $T_{17}$ — bei TTL- und MOS-Betrieb — ergibt sich aus:

$$\varDelta U_B T_{17} \approx \frac{|\varDelta U_B T_{10}|}{R_{11}} \left(1 - \frac{1}{B_T 10}\right) \cdot R_{39}.$$

$B_T 10 =$ Stromverstärkunsorgung von $T_{10}$

Im ECL-Betriebsfall ist ja $T_{15}$ leitend, so daß $R_{36}$ und $D_{24}$ nun zu $R_{39}$ parallel geschaltet sind, wodurch sich eine verringerte Basissteuerspannung für $T_{17}$ ergibt:

$$\varDelta U_B T_{17} \approx \frac{|\varDelta I_c T_{10}| \cdot R_{36} + |U_D 24 + U_{CE} T_{15}|}{R_{36} + R_{39}} \cdot R_{39}.$$

Die Dioden $D_{10}$ und $D_{11}$ dienen als Überspannungsschutz, indem Diode $D_{10}$ Transistor $T_8$ schützt — bei ausgangsseitiger Einspeisung von Spannungen positiver $U_B T_8$ (Diode $D_{10}$ sperrt); Diode $D_{11}$ dagegen schützt Transistor $T_{17}$ — bei ausgangsseitiger Einspeisung von Spannungen negativer $U_B T_{17}$ Diode $D_{11}$ sperrt).

Transistor $T_{11}$ verhindert ein Überschreiten der zulässigen Verlustleistung von $T_{17}$ bei Einspeisung von positiver Überspannung über den Ausgang. Die Basis-Emitter-Strecke von $T_{11}$ liegt über $R_{31}$

parallel zur Strecke $D_5$, $U_{BE}$ $T_8$, $D_{10}$ und $D_{11}$. Im Normalbetrieb addieren sich also drei Halbleiter-Durchlaß-Spannungen ($U_{BE}T_8 + U_D10 + U_D11 \triangleq 1,7$ V), wogegen sich von der Summenspannung die Durchlaß-Spannung von $D_5$ wieder subtrahiert, so daß Transistor $T_{11}$ durch die verbleibende Restspannung ($\triangleq 1,2$ V) ausreichend sicher gesperrt ist. Im Überspannungsfall wird nun diese Sperrspannung umgepolt (Diode $D_{10}$ beginnt zu sperren), die Basisspannung von $T_{11}$ bleibt dagegen vorerst unverändert. Über $R_{31}$ stellt sich nun ein Strom ein, da ja $T_{11}$ zu leiten beginnt. Dadurch wird nun Transistor $T_{16}$ leitend, der nun seinerseits — über Diode $D_4$ — das Basispotential von $T_8$ nach $V_{EE}$ absenkt. Damit sperrt auch Diode $D_5$, so daß über Transistor $T_{10}$ nur noch der kleine Basisstrom von Transistor $T_{11}$ fließt. Dieser Strom verursacht an $R_{39}$ jedoch nur einen minimalen Spannungsabfall ($\leqq 30$ mV), wodurch $T_{17}$ praktisch gesperrt wird. Dieser Zustand hält solange an, wie die externe positive Überspannung (max. $+30$ V) am Ausgang vorhanden ist. Bei Wegnahme der Überspannung kehrt die Schaltung selbsttätig wieder in den ursprünglichen Zustand zurück.

An der Basis von $T_{16}$ greift ferner auch über $R_{37}$ noch der Kollektor von Transistor $T_{18}$ an. Die Basis von $T_{18}$ ist über $R_{38}$ mit dem Programmiereingang Send-P verbunden. Liegt Eingang Send-P statisch auf TTL logisch »0«-Pegel ($\triangleq +0,4$ V), so wird $T_{18}$ leitend gesteuert, wodurch über $R_{37}$ auch Transistor $T_{16}$ durchschaltet, was denselben Abschaltvorgang bewirkt wie bei positiver Überspannungseinspeisung bereits geschildert wurde. Gleichzeitig zündet die Zenerdiode $D_{25}$, was einen Basisstrom für Transistor $T_{21}$ verursacht, wodurch dieser leitend wird und über Diode $D_{16}$ das Kathodenpotential von Diode $D_{11}$ nach $V_{cc}$ anhebt. Eingang »Send-P« sperrt also die Endstufenhalbleiter, so daß in diesem Fall nur die Sperrströme von $D_{10}$ und $D_{11}$ zusammen mit deren Sperrschichtkapazitäten als Ausgangsimpedanz in Erscheinung treten.

Im normalen Betriebsfall wird Transistor $T_4$ über die Widerstände $R_{16}$, $R_{17}$ ständig leitend gehalten. Tritt nun am Ausgang eine externe negative Überspannung ($\geqq -5$ V) auf, so zünden — über die Basis-Emitter-Strecke von $T_{12}$ und Diode $D_{12}$ — die Zenerdioden $D_8$ und $D_9$. Damit stellt sich über Widerstand $R_{19}$ ein Basisstrom für Transistor $T_5$ ein.

Transistor $T_5$ wird leitend und sperrt somit über Widerstand $R_{16}$ Transistor $T_4$, der seinerseits — über die Widerstände $R_{11}$, $R_{12}$ — Endstufentransistor $T_8$ von der Versorgungsspannung $V_{cc}$ abtrennt.

Durch diesen Vorgang wird bei Auftreten von externen negativen Überspannungen ($\geqq -5$ V bis $-30$ V) Transistor $T_8$ vor Zerstörung geschützt. Transistor $T_{17}$ ist ebenfalls geschützt, da ja in diesem Fall Diode $D_{11}$ sperrt.

Abgesehen von negativer Überspannung, muß die Emitterfolgerstufe $T_8$ bis zum Ansprechen der Überspannungsbegrenzung gegen Überstrombelastung (z. B. Kurzschlüsse im Prüfling) ausreichend geschützt werden. Diese Aufgabe übernimmt Widerstand $R_{12}$. An $R_{12}$ tritt in Abhängigkeit zum Emitter-Ausgangsstrom von $T_8$ ein stromproportionaler Spannungsabfall auf, der die $U_{CE}$ von $T_8$ entsprechend verringert, wodurch sich eine Kollektorverlustleistungsbegrenzung für $T_8$ ergibt:

$$P_C T_8 = [V_{CC} - U_E T_8 - |(I_E T_8 - I_B T_8)| R_{12}] \cdot (I_E T_8 - I_B T_8).$$

Nachdem der Sender im ECL-Sendefall sowohl abgeschlossene Leitungen ($Z = R = 50\ \Omega$), wie auch unabgeschlossene Leitungen reflexionsfrei treiben muß, war es erforderlich, den Einsatzpunkt der Strombegrenzung umzuschalten. Dies geschieht über Programmiereingang »HI-P« durch die Halbleiter $T_{22}$, $D_7$ und $T_9$. Wird z. B. — bei Ansteuerung einer unabgeschlossenen Leitung — der Eingang »HI-P« durch Anlegen von TTL statisch logisch »1« ($\triangleq +3,5$ V) aktiviert, so sperrt Transistor $T_9$ und trennt dadurch Widerstand $R_{12}$ von der Versorgungsspannung $V_{CC}$ ab. Transistor $T_8$ ist somit kollektorseitig stromlos, so daß er über seine Basis-Emitter-Strecke nur eine Diodenfunktion ausübt. Widerstand $R_{11}$ bleibt dagegen über den leitenden Transistor $T_4$ mit $V_{CC}$ verbunden; pegelbestimmendes aktives Element ist in diesem Fall Transistor $T_{10}$ (Emitterfolgerstufe) wobei bei positiver Flanke der Ausgangsstrom gemäß

$$\Delta I_\uparrow = \dfrac{\Delta \dfrac{U_{ECL}}{2}}{Z}$$

nur durch Widerstand $R_{11}$ (Konstantstromfunktion bezüglich des relativ kleinen ECL-Pegels) bestimmt wird. Der Ausgangsstrom für die doppelte Laufzeit bei positiver Flanke der unabgeschlossenen ECL-Leitung beträgt demnach:

$$I_{A\uparrow} = \dfrac{|V_{CC} - U_{CE}T_4 - (U_{BE}T_8 + U_D10) + 1,2|}{R_{11}}.$$

$1,2$ = Betrag der Mittenspannung des ECL-Pegels

Transistor $T_{10}$ bzw. Diode $D_5$ sind in diesem Fall — also während der doppelten Laufzeit der angeschlossenen Leitung — gesperrt, so daß auch durch $R_{39}$ kein Strom fließt und somit Transistor $T_{17}$ ebenfalls gesperrt wird. Erst nach Eintreffen des von der Leitung reflektierten Impulses werden $T_{10}$ und

somit auch $T_{17}$ wieder aktiv, wodurch sich in der Endstufe ein Querstrom einstellt. Für die negative Flanke wiederholt sich obiger Vorgang in umgekehrter Richtung. Transistor $T_{17}$ Konstantstromquelle) liefert nun den Umladestrom gemäß

$$\varDelta I_{\downarrow} = \frac{\varDelta \dfrac{U_{ECL}}{2}}{Z}$$

während für die doppelte Laufzeit der angeschlossenen Leitung Transistor $T_8$ bzw. Diode $D_{10}$ sperren. Erst nach Eintreffen des reflektierten Impulses werden $T_8$ und $D_{10}$ wieder aktiv, und es stellt sich wiederum ein Querstrom ein. Pegelbestimmend in beiden Fällen bleibt nach abgelaufener Reflexion Transistor $T_{10}$ mit seiner Emitterfolgerfunktion.

Die Diode $D_5$ kompensiert den Temperaturgang der Diode $D_{10}$. Die Diode $D_6$ schützt die Basis-Emitter-Strecke von $T_9$ vor zerstörendem Durchbruch bei ausgangsseitiger Überspannungseinspeisung im Bereich von

$-5\,V$ bis $-30\,V$.

Der statische Ausgangswiderstand beträgt im Normalbetrieb, d. h. ohne Ansteuerung des Eingangs »Hi-P«:

$$R_{IA} = \left( \frac{U_{CE}T_{17}}{I_C T_{17}} + R_{41} + r_{D11} \right) \Big| \Big| \left( \frac{r_{BE}T_8 \cdot I_B T_8}{I_C T_8} + \frac{R_g}{B_T 8} + r_{D10} \right).$$

$R_g$ = Generatorinnenwiderstand an der Basis von $T_8$
$B_T 8$ = Stromverstärkung von $T_8$

Der Empfänger wird wie folgt aufgebaut: Die Transistorstufen $T_{12}$ und $T_{13}$ bilden über die Diodenstrecken $D_{12}$ und $D_{13}$ einen Differenzverstärker, der — um einen großen Gleichtakt-Bereich zu erhalten — durch Transistor $T_6$ emitterseitig mit Konstantstrom versorgt wird. Der Spannungsteiler $R_{17}$ zu $R_{16}$, $U_{BE}T_4$ erzeugt für $T_6$ die Basisvorspannung. Die $U_{BE}$ von $T_4$ wirkt hierbei kompensierend auf den Temperaturgang der $U_{BE}$ von Transistor $T_6$ ein. Für den Kollektorstrom von $T_6$ gilt dann:

$$I_C T_6 = \frac{\dfrac{V_{CC} - |U_{BE}T_4|}{R_{16} + R_{17}} \cdot R_{16} + |U_{BE}T_4| - |U_{BE}T_6|}{R_{14}} \left( 1 - \frac{1}{B_T 6} \right)$$

Transistor $T_5$ ist im Normalfall gesperrt.

Als Kolektorwiderstände für $T_{12}$ und $T_{13}$ dienen die Widerstände $R_{32}$ bzw. $R_{33}$, denen jeweils eine Schottky-Diode $D_{17}$ und $D_{18}$ zur Amplitudenbegrenzung parallel geschaltet wurde. Dies bietet den Vorteil, daß der Verstärkungsfaktor — bei ausreichend hochohmig dimensionierten $R_{32}$ und $R_{33}$ — groß sein kann, wogegen aufgrund der Amplitudenbegrenzung von $D_{17}$ und $D_{18}$ und der sich dadurch ergebenden kleinen Kollektorspannungsamplituden ($\cong 400\,mV$) der »Miller-Effekt« (Rückwirkung Kollektor-Basis-Kapazität multipliziert sich mit Verstärkungsfaktor bei $T_{12}$ und $T_{13}$) noch nicht maßgebend in Erscheinung tritt. Außerdem werden die Eingänge des Komparators ($K_1$) vor differentieller Übersteuerung geschützt.

Der Spannungsabfall an $R_{43}$ fixiert den DC-Arbeitspunkt für die Eingänge des Komparators $K_1$; durch $R_{43}$ fließt der Summen-Kollektorstrom von $T_{12}$ und $T_{13}$ ($\cong$ Kollektorstrom der Konstantstromquelle $T_6$).

Die Dioden $D_{12}$ und $D_{13}$ verhindern eine Zerstörung der Transistoren $T_{12}$ und $T_{13}$ bei Durchbruch der Basis-Emitter-Strecke in Sperr-Richtung. Dies geschieht beispielsweise bei großen Differenzspannungen zwischen dem Referenzspannungseingang $U_v$ ($\cong$ Basisspannung an $T_{13}$) und dem Meßeingang ($\cong$ Basisspannung an $T_{12}$). Liegt Eingang $U_v$ z. B. auf 0 Volt und die Basis von $T_{12}$ über $R_{44}$ an $+30\,V$, so wird die Diode $D_{12}$ gesperrt und ein zerstörender Durchbruch der Basis-Emitter-Strecke von $T_{12}$ verhindert.

Die Dioden $D_{14}$ und $D_{15}$ schützen die Eingänge des Komparators $K_1$ vor zerstörender Überspannung. Liegt der Meßeingang ($\cong$ Basis $T_{12}$) z. B. auf $-30\,V$, so ist Transistor $T_{12}$ voll in Sättigung, d. h. die Kollektor-Basis-Diode ist leitend, wodurch die Kollektorspannung von $T_{12}$ den Wert

$$U_C = U_B - U_{CB}$$

also ca. $-29,3\,V$ annimmt. Dadurch ist die Diode $D_{14}$ gesperrt und der Eingang 3 des Komparators $K_1$ ausreichend geschützt.

Ferner zünden bei negativer Überspannungseinspeisung ($\geqq -5\,V$ bis $-30\,V$) auch noch die beiden Zenerdioden $D_8$ und $D_9$, so daß sich über $R_{19}$ ein Basisstrom für Transistor $T_5$ einstellt. $T_5$ wird leitend und bindet somit die Basis von $T_6$ an $V_{CC}$. Dadurch ist Transistor $T_6$ gesperrt und kollektorverlustlei-

**0 032 222**

tungsmäßig geschützt.

Komparator $K_1$ bewertet die Differenzspannung an den Widerständen $R_{32}$ und $R_{33}$. Er beinhaltet ferner das »Istwert-Flipflop« (taktzustandgesteuertes D-Flipflop).

Liegt der Eingang »Abtast-P« z. B. statisch auf ECL logisch »1«-Pegel ($= -0,8$ V), so ändern sich die Komparatorausgänge »Out-N« digital zeitlich analog zur Polarität der Eingangsdifferenzspannung. Wird dagegen der Eingang »Abtast-P« auf ECL logisch »0«-Pegel ($= -1,8$ V) geschaltet, so wird diejenige Information an den Ausgängen digital gespeichert, die zum Zeitpunkt der Abschaltflanke als differentieller analoger Spannungswert an den Eingängen lag. Die Mindestbreite des Abtastimpulses beträgt 3 ns.

**Patentansprüche**

1. Prüfeinrichtung für ein automatisches Prüfsystem zur Funktionsprüfung von integrierten Schaltkreisen unterschiedlicher Schaltkreisfamilien wie TTL-, ECL- und MOS-Schaltkreisen, bestehend aus

- einem Sender (S) zur Erzeugung von binären Prüfsignalen eines der Familie des jeweiligen Prüflings (5) angepaßten Signalpegels, welcher Sender eine steuerbare Konstantstromquelle (SQ) und eine an deren Ausgang angeschlossene Endstufe (ES) aufweist, deren Ausgang an einen Prüfstift (PA) angeschlossen ist, an den der Ein- bzw. Ausgang des Prüflings (5) anschließbar ist,
- einem Empfänger (VS, K1) für die Ausgangssignale des Prüflings,
- und einer Versorgungsspannungsquelle mit einer ersten Klemme (VEE) für einen ersten Spannungspegel einer ersten Polarität und einer zweiten Klemme (VCC) für einen zweiten Spannungspegel entgegengesetzter Polarität,

dadurch gekennzeichnet, daß

- an der Konstantstromquelle (SQ) ein deren Konstantstrom tastendes, auf Null Volt bezogenes TTL-Eingangssignal anliegt,
- eine Programmierschaltung (PS) vorgesehen ist, die abhängig von an ihren beiden Programmiereingängen (TTL-P, ECL-P) angelegten TTL-Pegeln den Ausgang der Konstantstrom- . quelle (SQ) mit unterschiedlichen Widerständen (R26, R27, R28) belastet, die das Ausgangssignal der Konstantstromquelle derart beeinflussen, daß die Endstufe den der Familie des jeweils untersuchten Prüflings angepaßten Ausgangspegel aufweist,
- die Endstufe (ES) eine in Abhängigkeit von ihrem Ausgangspegel gesteuerte Last (T17) enthält,
- und daß der Empfänger aus einer mit einer Referenzspannung (Uv) versorgten Vergleicherschaltung (VS) und einem dieser nachgeschalteten Speicher (K1) besteht und eingangsseitig außer mit dem Prüfstift (PA) auch mit dem Ausgang der Endstufe (ES) verbunden ist.

2. Prüfeinrichtung nach Anspruch 1, dadurch gekennzeichnet, daß die Konstantstromquelle (SQ) aus einem ersten Transistor (T1) in Emitterschaltung und einem diesem nachgeschalteten zweiten Transistor (T2) in Basisschaltung besteht.

3. Prüfeinrichtung nach einem der vorhergehenden Ansprüche, dadurch gekennzeichnet, daß die Endstufe (ES) aus einem dritten und einem vierten Transistor (T10, T8) besteht, die als Emitterfolger geschaltet sind, in dessen Ausgangskreis ein in Abhängigkeit vom Ausgangspegel gesteuerter fünfter Transistor (T17), der als die gesteuerte Last wirkt, liegt, und daß die Basis dieses fünften Transistors (T17) an den Verbindungspunkt des Kollektors des dritten Transistors (T10) mit dessen Kollektorwiderstand (R39) geführt ist.

4. Prüfeinrichtung nach einem der vorhergehenden Ansprüche, dadurch gekennzeichnet, daß die Programmierschaltung einen sechsten und einen siebenten Transistor (T14, T15) aufweist, die kollektorseitig jeweils über eine erste bzw. zweite Reihenschaltung aus einer ersten Diode (D19) und einem ersten Ohmschen Widerstand (R26) bzw. einer zweiten Diode (D23) und einem zweiten Ohmschen Widerstand (R27) mit dem Eingang der Endstufe (ES) und dem Ausgang der Konstantstromquelle (SQ) und emitterseitig mit der ersten Klemme (VEE) der Versorgungsspannungsquelle verbunden sind, daß parallel zu den Reihenschaltungen (D19, R26 bzw. D23, R27) und dem sechsten bzw. siebenten Transistor (T14, T15) ein dritter Ohmscher Widerstand (R28) geschaltet ist, der so dimensioniert ist, daß im Sperrzustand des sechsten und siebenten Transistors (T14, T15) am Ausgang der Endstufe (ES) MOS-»logisch 1« Pegel liegt, daß ein achter Transistor (T7) über eine erste Zenerdiode (D3) emitterseitig mit dem Eingang der Endstufe (ES) und dem Ausgang der Konstantstromquelle (SQ) und kollektorseitig mit der zweiten Klemme (VCC) der Versorgungsspannungsquelle verbunden ist, daß die Basis des sechsten bzw. siebten Transistors (T14, T15) über zweite bzw. dritte Zenerdioden (D20, D21) mit einem TTL-Logikpegel ansteuerbar sind, und die Basis des achten Transistors (T7) an den Abgriff eines ersten Spannungsteilers aus zwei Widerständen (R8, R21), der zwischen der zweiten Klemme (VCC) und Masse liegt, geführt ist, daß zwischen dem Abgriff dieses ersten Spannungsteilers (R8, R21) und dem Kollektor des siebenten Transistors (T15) eine dritte Reihenschaltung aus einem vierten Ohmschen Widerstand (R22) und einer dritten Diode (D22) angeordnet ist und daß die Widerstände (R26, R27) der ersten und zweiten Reihenschaltung so dimensioniert sind, daß bei Sperrzustand jeweils des sechsten bzw. siebenten Transistors (T14, T15) TTL-»logisch 1« Pegel bzw. ECL-»logisch 1« Pegel am Ausgang der Endstufe (ES) ansteht.

5. Prüfeinrichtung nach einem der vorhergehenden Ansprüche, dadurch gekennzeichnet, daß die Eingänge (TTL-P, ECL-P) der Programmierschaltung (PS) über einen neunten bzw. zehnten Transistor (T19, T20) in Kollektorschaltung angesteuert sind, an deren Eingängen jeweils die zur Programmierung erforderlichen TTL-Logikpegel anlegbar sind.

6. Prüfeinrichtung nach Anspruch 4, dadurch gekennzeichnet, daß zwischen den beiden Spannungsteilerwiderständen (R8, R21) des ersten Spannungsteilers eine vierte Diode (D2) angeordnet ist.

7. Prüfeinrichtung nach einem der vorhergehenden Ansprüche, dadurch gekennzeichnet, daß die Basis des als gesteuerte Last wirkenden fünften Transistors (T17) der Endstufe über einen fünften Ohmschen Widerstand (R36) und eine fünfte Diode (D24) mit dem Kollektor des siebenten Transistors (T15) der Programmierschaltung (PS) verbunden ist.

8. Prüfeinrichtung nach einem der vorhergehenden Ansprüche, dadurch gekennzeichnet, daß zwischen dem Emitter des vierten Transistors (T8) der Endstufe (ES) und dem als gesteuerte Last geschalteten fünften Transistor (T17) eine vierte und fünfte Zenerdiode (D10, D11) liegen, an deren Verbindungspunkt die Ausgangsspannung der Endstufe abgegriffen wird.

9. Prüfeinrichtung nach einem der vorhergehenden Ansprüche, dadurch gekennzeichnet, daß der dritte und vierte Transistor (T10, T8) über eine sechste Zenerdiode (D5) miteinander verbunden sind, und daß der Emitter des dritten Transistors (T10) mit der Basis eines zusätzlichen elften Transistors (T11) verbunden ist, dessen Kollektor über einen sechsten Ohmschen Widerstand (R40) an die erste Klemme (VEE) und dessen Emitter über einen siebenten Ohmschen Widerstand (R31) an den Kollektor des fünften Transistors (T17) geführt ist, daß die Basis eines zwölften Transistors (T16), dessen Emitter und Kollektor jeweils an einer der Klemmen (VEE, VCC) der Versorgungsspannungsquelle (VCC, VEE) liegen mit dem Kollektor des elften Transistors (T11) verbunden ist und daß der Kollektor des zwölften Transistors (T16) außerdem über eine siebte Zenerdiode (D4) an die Basis des vierten Transistors (T8) geführt ist.

10. Prüfeinrichtung nach Anspruch 9, dadurch gekennzeichnet, daß der Kollektor eines dreizehnten Transistors (T18) über einen achten Ohmschen Widerstand (R37) an die Basis des zwölften Transistors (T16) geführt ist, daß die Basis des dreizehnten Transistors (T18) als dritter Programmiereingang (Send-P) mit einem statischen TTL-Pegel beaufschlagbar ist, und daß die Kollektoren des zwölften Transistors (T16) und des dritten Transistors (T10) über eine achte Zenerdiode (D26) miteinander verbunden sind.

11. Prüfeinrichtung nach einem der vorhergehenden Ansprüche, dadurch gekennzeichnet, daß die Vergleichsschaltung (VS) des Empfängers eine aus einem vierzehnten und fünfzehnten Transistor (T12, T13) bestehende Differenzverstärkerschaltung ist, an deren einem Eingang der Ausgang des Senders (S) und an deren anderem Eingang die Referenzspannung (Uv) liegt.

12. Prüfeinrichtung nach Anspruch 11, dadurch gekennzeichnet, daß den Kollektorwiderständen (R32, R33) des vierzehnten und fünfzehnten Transistors (T12, T13) Schottky-Dioden (D17, D18) parallel geschaltet sind.

13. Prüfeinrichtung nach Anpruch 12, dadurch gekennzeichnet, daß die Kollektorwiderstände (R32, R33) des vierzehnten und fünfzehnten Transistors (T12, T13) über einen gemeinsamen Widerstand (R43) an der ersten Klemme (VEE) liegen.

14. Prüfeinrichtung nach Anspruch 13, dadurch gekennzeichnet, daß zu den Kollektorwiderständen (R32, R33) des vierzehnten und fünfzehnten Transistors (T12, T13) jeweils eine neunte und zehnte Zenerdiode (D14, D15) in Reihe geschaltet ist.

15. Prüfeinrichtung nach einem der Ansprüche 11 bis 13, dadurch gekennzeichnet, daß in den Emitterzweigen des vierzehnten und fünfzehnten Transistors (T12, T13) der Vergleichsschaltung (VS) eine sechste und eine siebte Diode (D12, D13) liegen.

16. Prüfeinrichtung nach einem der vorhergehenden Ansprüche, dadurch gekennzeichnet, daß der Speicher (K1) des Empfängers aus einem taktgesteuerten D-Flipflop besteht, dem als Abtastspannung ein logischer ECL-Pegel zuführbar ist.

17. Prüfeinrichtung nach Anspruch 15, dadurch gekennzeichnet, daß die Emitter des vierzehnten und fünfzehnten Transistors (T12, T13) über einen neunten Ohmschen Widerstand (R19), eine elfte und zwölfte Zenerdiode (D8, D9) und einen zehnten Ohmschen Widerstand (R15) mit der zweiten Klemme (VCC) verbunden sind.

18. Prüfeinrichtung nach Anspruch 17, dadurch gekennzeichnet, daß parallel zu den Elementen im gemeinsamen Emitterkreis des vierzehnten und fünfzehnten Transistors (T12, T13) ein sechzehnter Transistor (T6) liegt, dessen Basis mit dem Abgriff eines zweiten Spannungsteilers (R16, R17) verbunden ist.

19. Prüfeinrichtung nach Anspruch 18, dadurch gekennzeichnet, daß im Kollektorkreis des vierten Transistors (T8) die Kollektor-Emitterstrecke eines im normalen Betriebsfall leitenden siebzehnten

9

Transistors (T4) liegt, dessen Basis über den zweiten Spannungsteiler (R16, R17) an Masse geführt ist, daß zwischen Abgriff des zweiten Spannungsteilers (R16, R17) und der zweiten Klemme (VCC) die Kollektor-Emitterstrecke eines achtzehnten Transistors (T5) liegt, dessen Basis an den Verbindungspunkt des zehnten Ohmschen Widerstandes (R15) mit der elften Zenerdiode (D8) geführt ist.

20. Prüfeinrichtung nach Anspruch 19, dadurch gekennzeichnet, daß zwischen den Kollektor des vierten Transistors (T8) der Endstufe (ES) und den Kollektor des siebzehnten Transistors (T4) ein elfter Ohmscher Widerstand (R12) eingeschaltet ist.

21. Prüfeinrichtung nach Anspruch 20, dadurch gekennzeichnet, daß zwischen dem elften Ohmschen Widerstand (R12) und dem Kollektor des siebzehnten Transistors (T4) die Kollektor-Emitter-Strecke eines neunzehnten Transistors (T9) liegt, dessen Basis über eine dreizehnte Zenerdiode (D7) und den Emitter eines zwanzigsten Transistors (T22) angesteuert wird und dessen Basis einen vierten Programmiereingang (HI-P) bildet, an dem ebenfalls ein logisches TTL-Signal anlegbar ist.


## Claims

1. Test apparatus for an automatic test system for function testing integrated circuits of different circuit families such as TTL, ECL and MOS circuits, composed of

a transmitter (S) which generates binary test signals of a signal level matched to the family of the particular specimen (5) to be tested, which transmitter possesses a controllable constant current source (SQ) connected to a power output stage (ES) whose own output is connected to a test pin (PA) to which the input and output of the specimen (5) to be tested can be connected,
a receiver (VS, K1) for the output signals of the specimen to be tested,
and a supply voltage source with a first terminal (VEE) for a first voltage level of a first polarity and a second terminal (VCC) for a second voltage level of the opposite polarity,

characterised in that

the constant current source (SQ) is connected to a TTL-input signal which keys the constant current thereof and is related to zero volts,
a programming circuit (PS) is provided which loads the output of the constant current source (SQ) with different resistors (R26, R27, R28) in dependence upon TTL levels present at its two programming inputs (TTL-P, ECL-P), to influence the output signal of the constant current source in such manner that the power output stage possesses the output level matched to the family of the specimen which is to be tested,
the end stage (ES) contains a load (T17) which is controlled in dependence upon its output level,
and that the receiver consists of a comparator circuit (VS) supplied with a reference voltage (Uv), and a following store (K1), and connected at its input to the test pin (PA) and to the output of the power output stage (ES).

2. Test apparatus as claimed in Claim 1, characterised, in that the constant current source (SQ) consists of a first transistor (T1) connected in a common emitter circuit and a subsequent second transistor (T2) connected in a common base circuit.

3. Test apparatus as claimed in one of the preceding Claims, characterised in that the power output stage (ES) consists of a third and a fourth transistor (T10, T8) connected as an emitter follower whose output circuit contains a fifth transistor (T17) controlled in dependence upon the output level to act as the controlled load, and that the base of this fifth transistor (T17) leads to the junction point of the collector of the third transistor (T10) and the collector resistor (R39) thereof.

4. Test apparatus as claimed in one of the preceding Claims, characterised in that the programming circuit possesses a sixth and a seventh transistor (T14, T15) which have their collectors each connected via a first and second series arrangement composed of a first diode (D19) and a first resistor (R26) and of a second diode (D23) and a second resistor (R27) to the input of the power output stage (ES) and the output of the constant current source (SQ), and at their emitters connected to the first terminal (VEE) of the supply voltage source, that parallel to the series arrangements (D19, R26 and D23, R27) and the sixth and seventh transistors (T14, T15) there is connected a resistor (R28) dimensioned in such manner that when the sixth and seventh transistors (T14, T15) are in the blocked state the MOS level »logic 1« prevails at the output of the power output stage (ES), that an eighth transistor (T7) has its emitter connected via a first Zener diode (D3) to the input of the power output stage (ES) and to the output of a constant current source (SQ) and its collector to the second terminal (VCC) of the supply voltage source, that the base of the sixth and seventh transistors (T14, T15) can be driven via second and third Zener diodes (D20, D21) with a TTL logic level, and the base of the eighth transistor (T7) leads to the tapping of a first voltage divider composed of two resistors (R8, R21) arranged between the second terminal (VCC) and earth, that between the tapping of this first voltage divider (R8, R21) and the collector of the seventh transistor (T15) there is arranged a third series arrangement composed of a fourth resistor (R22) and a third diode (D22) and that the resistors (R26, R27) of the first and second series arrangements are dimensioned in such manner that when the sixth and seventh transistors (T14, T15) are each blocked, the TTL logic level »1« or the ECL logic level »1« occur respectively at the output of the end stage (ES).

5. Test apparatus as claimed in one of the preceding Claims, characterised in that the inputs (TTL-P, ECL-P) of the programming circuit (PS) are driven via a ninth and tenth transistor (T19, T20) connected in a common collector circuit, whose inputs can each be connected to the TTL logic level necessary for programming.

6. Test apparatus as claimed in Claim 4, characterised in that a fourth diode (D2) is arranged between the two voltage divider resistors (R8, R21) of the first voltage divider.

7. Test apparatus as claimed in one of the preceding Claims, characterised in that the base of the fifth transistor (T17) which acts as controlled load and forms part of the power output stage is connected via a fifth resistor (R36) and a fifth diode (D24) to the collector of the seventh transistor (T15) of the programming circuit (PS).

8. Test apparatus as claimed in one of the preceding Claims, characterised in that between the emitter of the fourth transistor (T8) of the power output stage (ES) and the fifth transistor (T17) which is connected as controlled load there are arranged a fourth and fifth Zener diode (D10, D11) from the junction point of which the output voltage of the power output stage ist tapped.

9. Test apparatus as claimed in one of the preceding Claims, characterised in that the third and fourth transistors (T10, T8) are connected to one another via a sixth Zener diode (D5), and that the emitter of the third transistor (T10) is connected to the base of an additional eleventh transistor (T11) whose collector leads via a sixth resistor (R40) to the first terminal (VEE) and whose emitter leads via a seventh resistor (R31) to the collector of the fifth transistor (T17), that a twelfth transistor (T16), whose emitter and collector are each connected to one of the terminals (VEE, VCC) of the supply voltage source (VCC, VEE), has its base connected to the collector of the eleventh transistor (T11), and that the collector of the twelfth transistor (T16) also leads via a seventh Zener diode (D4) to the base of the fourth transistor (T8).

10. Test apparatus as claimed in Claim 9, characterised in that the collector of a thirteenth transistor (T18) leads via an eighth resistor (R37) to the base of the twelfth transistor (T16), that the base of the thirteenth transistor (T18), can be supplied with a static TTL-level as a third programming input (Send-P) and that the collectors of the twelfth transistor (T16) and the third transistor (T10) are connected to one another via an eighth Zener diode (D26).

11. Test apparatus as claimed in one of the preceding Claims, characterised in that the comparator circuit (VS) of the receiver consists of a differential amplifier circuit which is composed of a fourteenth and fifteenth transistor (T12, T13) and whose first input is connected to the output of the transmitter (S) and whose other input is connected to the reference voltage (Uv).

12. Test apparatus as claimed in Claim 11, characterised in that Schottky diodes (D17, D18) are connected in parallel to the colektor resistors (R23, R33) of the fourteenth and fifteenth transistors (T12, T13).

13. Test apparatus as claimed in Claim 12, characterised in that the collector resistors (R32, R33) of the fourteenth and fifteenth transistors (T12, T13) are connected via a common resistor (R43) to the first terminal (VEE).

14. Test apparatus as claimed in Claim 13, characterised in that a ninth and tenth Zener diode (D14, D15) are in each case connected in series to the collector resistors (R32, R33) of the fourteenth and fifteenth transistors (T12, T13).

15. Test apparatus as claimed in one of the Claims 11 to 13, characterised in that the emitter arms of the fourteenth and fifteenth transistors (T12, T13) of the comparator circuit (VS) contain a sixth and seventh diode (D12, D13).

16. Test apparatus as claimed in one of the preceding Claims, characterised in that the store (K1) of the receiver consists of a clock-pulse controlled D-type flip-flop stage which can be supplied with a logic ECL level as sampling voltage.

17. Test apparatus as claimed in Claim 15, characterised in that the emitters of the fourteenth and fifteenth transistors (T12, T13) are connected to the second terminal (VCC) via a ninth resistor (R19), an eleventh and twelfth Zener diode (D8, D9), and a tenth resistor (R15).

18. Test apparatus as claimed in Claim 17, characterised in that the elements contained in the common emitter circuit of the fourteenth and fifteenth transistors (T12, T13) are arranged in parallel to a sixteenth transistor (T6) whose base is connected to the tapping of a second voltage divider (R16, R17).

19. Test apparatus as claimed in Claim 18, characterised in that the collector circuit of the fourth transistor (T8) contains the collector-emitter path of a seventeenth transistor (T4) which is conductive during normal operation and whose base leads to earth via the second voltage divider (R16, R17) that between the tapping of the second voltage divider (R16, R17) and the second terminal (VCC) there is arranged the collector-emitter path of an eighteenth transistor (T5) whose base leads to the junction point of the tenth resistor (R15) to the eleventh Zener diode (D8).

20. Test apparatus as claimed in Claim 19, characterised in that an eleventh resistor (R12) is connected between the collector of the fourth transistor (T8) of the power output stage (ES) and the collector of the seventeenth transistor (T7).

21. Test apparatus as claimed in Claim 20, characterised in that between the eleventh resistor (R12) and the collector of the seventeenth transistor (T4) is arranged the collector emitter path of a nineteenth transistor (T9) whose base is driven via a thirteenth Zener diode (D7) and the emitter of a twentieth transistor (T22) and whose base forms a fourth programming input (HI-P) to which a logic TTL signal can likewise be connected.

## Revendications

1. Equipement de test pour un système de test automatique pour tester le fonctionnement de circuits intégrés de différentes familles de circuits intégrés tels que des circuits intégrés TTL, ECL et MOS constitué par

— un émetteur (S) pour la production de signaux de test binaires possédant un niveau de signal adapté à la famille de l'échantillon respectif (5), émetteur qui comporte une source de courant constant commandable (SQ) et un étage final (ES) raccordé à sa sortie, et dont la sortie est reliée à une broche de test (PA) à laquelle peut être raccordée l'entrée ou la sortie de l'échantillon (5),
— un récepteur (VS, K1) pour les signaux de sortie de l'échantillon
— etune source de tension d'alimentation qui comporte une première borne (VEE) pour un premier niveau de tension possédant une première polarité et une seconde borne (VCC) pour un second niveau de tension de polarité opposée,

caractérisé par le fait que,

— à la source de courant constant (SQ) est appliqué un signal d'entrée TTL rapporté à une tension nulle et manipulant son courant constant,
— qu'il est prévu un circuit de programmation (PS) qui, en fonction des niveaux TTL appliqués sur ses deux entrées de programmation (TTL-P, ECL-P), charge la sortie de la source de courant constant (SQ) à l'aide de différentes résistances (R26, R27, R28) qui agissent sur le signal de sortie de la source de courant constant de manière que l'étage final présente le niveau de sortie adapté à la · famille de l'échantillon respectivement testé,
— l'étage final (ES) comprend une charge (T17) commandée en fonction de son niveau de sortie,
— et que le récepteur est constitué par un circuit comparateur (VS) alimenté par une tension de référence ($U_v$) et une mémoire (K1) montée en aval de celuici, et est relié côté entrée, outre à la broche de test (PA), également à la sortie de l'étage final (ES).

2. Equipement de test suivant la revendication 1, caractérisé par le fait que la source de courant constant (SQ) est constituée par un premier transistor (T1) monté en émetteur commun et par un second transistor (T2) monté en base commune qui est disposé en aval du premier.

3. Equipement de test suivant l'une des revendications précédentes, caractérisé par le fait que l'étage final (ES) est constitué par un troisième et un quatrième transistors (T10, T8) qui sont ontés en émetteur suiveur, dans le circuit de sortie desquels se trouve un cinquième transistor (T17) qui est commandé en fonction du niveau de sortie et qui agit comme une charge commandée, et que la base du cinquième transistor (T17) est reliée au point de jonction du collecteur du troisième transistor (T10) avec sa résistance de collecteur (R39).

4. Equipement de test suivant l'une des revendications précédentes, caractérisé par le fait que le circuit de programmation comporte un sixième et un septième transistors (T14, T15) qui, côté collecteur, sont respectivement reliés, par l'intermédiaire d'un premier ou d'un second circuit série, constitué par une première diode (D19) et une première résistance ohmique (R26) ou par une seconde diode (D23) et une seconde résistance ohmique (R27), à l'entrée de l'étage final (ES) et à la sortie de la source de courant constant (SQ) et, côté émetteur, à la première borne (VEE) de la source de tension d'alimentation, qu'en parallèle sur les circuits série (D19, R26 ou D23, R27) et le sixième ou le septième transistor (T14, T15) est montée une troisième résistance ohmique (R28) qui es dimensionnée de manière que dans l'état bloqué du sixième et du septième transistors (T14, T15) il existe un niveau logique »1« MOS sur la sortie de l'étage final (ES), qu'un huitième transistor (T7) est relié côté émetteur, par l'intermédiaire d'une première diode Zener (D3), à l'entrée de l'étage final (ES) et à la sortie de la source de courant constant (SQ) et côté collecteur à la seconde borne (VCC) de la source de tension d'alimentation, que la base du sixième ou du septième transistor (T14, T15) peut être commandée, par l'intermédiaire de la seconde ou de la troisième diode Zener (D20, D21), par un niveau logique TTL, et la base du huitième transistor (T7) est reliée à la prise d'un premier diviseur de tension, constitué par deux résistances (R8, R21), qui se trouve entre la seconde borne (VCC) et la masse, qu'entre la prise de ce premier diviseur de tension (R8, R21) et le collecteur de septième transistor (T15) est disposé un troisième circuit série constitué par une quatrième résistance ohmique (R22) et une troisième diode (D22), et que les résistances (R26, R27) des premier et second circuits série sont dimensionnés de manière que dans l'état bloqué respectivement du sixième ou du septième transistor (T14, T15) il apparaisse un niveau logique »1« TTL ou un niveau logique »1« ECL sur la sortie de l'étage final (ES).

5. Equipement de test suivant l'une des revendications précédentes, caractérisé par le fait que les entrées (TTL-P, ECL-P) du circuit de programmation (PS) sont commandées par l'intermédiaire d'un neuvième ou d'un dixième transistor (T19, T20) monté en collecteur commun, sur les entrées desquels peuvent être respectivement appliqués les niveaux logiques TTL nécessaires pour la programmation.

6. Equipement de test suivant la revendication 4, caractérisé par le fait qu'une quatrième diode (D2) est disposée entre les deux résistances (R8, R21) du premier diviseur de tension.

7. Equipement de test suivant l'une des revendications précédentes, caractérisé, par le fait que la base du cinquième transistor (T17) de l'étage final, qui agit comme une charge commandée, est reliée au collecteur du septième transistor (T15) du circuit de programmation (PS), par l'intermédiaire d'une cinquième résistance ohmique (R36) et d'une cinquième diode (D24).

8. Equipement de test suivant l'une des revendications précédentes, caractérisé par le fait qu'entre l'émetteur du quatrième transistor (T8) de l'étage final (ES) et le cinquième transistor (T17), monté comme une charge commandée, se trouvent une quatrième et une cinquième diode Zener (D10, D11) au niveau du point de jonction desquelles est prélevée la tension de sortie de l'étage final.

9. Equipement de test suivant l'une des revendications précédentes, caractérisé par le fait que le troisième et le quatrième transistors (T10, T8) sont reliés l'un avec l'autre par l'intermédiaire d'une sixième diode Zener (D5), et que l'émetteur du troisième transistor (T10) est relié à la base d'un onzième transistor supplémentaire (T11) dont le collecteur est relié, par l'intermédiaire d'une sixième résistance ohmique (R40), à la première borne (VEE) et dont l'émetteur est relié, par l'intermédiaire d'une septième résistance ohmique (R13), au collecteur du cinquième transistor (T17), que la base d'un douzième transistor (T16), dont l'émetteur et le collecteur sont respectivement reliés à une des bornes (VEE, VCC) de la source de tension d'alimentation (VCC, VEE), est reliée au collecteur du onzième transistor (T11), et que le collecteur du douzième transistor (T16) est en outre relié, par l'intermédiaire d'une septième diode Zener (D4), à la base du quatrième transistor (T8).

10. Equipement de test suivant la revendication 9, caractérisé par le fait que le collecteur d'un treizième transistor (T18) est relié à la base du douzième transistor (T16) par l'intermédiaire d'une huitième résistance ohmique (R37), que la base du treizième transistor (T18) peut recevoir, en tant que troisième entrée de programmation (EMET-P), un niveau TTL statique, et que les collecteurs du douzième transistor (T16) et du troisième transistor (T10) sont reliés l'un à l'autre par l'intermédiaire d'une huitième diode Zener (D26).

11. Equipement de test suivant l'une des revendications précédentes, caractérisé par le fait que le circuit comparateur (VS) du récepteur est un circuit amplificateur différentiel, constitué par un quatorzième et un quinzième transistors (T12, T13), à une entrée duquel est reliée la sortie de l'émetteur (S) et à l'autre entrée duquel est appliquée la tension de référence (Uᵥ).

12. Equipement de test suivant la revendication 11, caractérisé par le fait que des diodes Schottky (D17, D18) sont montées en parallèle sur les résistances de collecteur (R32, R33) du quatorzième et du quinzième transistors (T12, T13).

13. Equipement de test suivant la revendication 12, caractérisé par le fait que les résistances de collecteur (R32, R33) des quatorzième et quinzième transistors (T12, T13) sont reliées, par l'intermédiaire d'une résistance commune (R43), à la première borne (VEE).

14. Equipement de test suivant la revendication 13, caractérisé par le fait qu'une neuvième et une dixième diodes Zener (D14, D15) sont respectivement montées en série avec les résistances de collecteur (R32, R33) du quatorzième et du quinzième transistors (T12, T13).

15. Equipement de test suivant l'une des revendications 11 à 13, caractérisé par le fait qu'une sixième et une septième diodes (D12, D13) sont montées dans le circuit d'émetteur du quatorzième et du quinzième transistors (T12, T13) du circuit comparateur (VS).

16. Equipement de test suivant l'une des revendications précédentes, caractérisé par le fait qu'à la mémoire (K1) du récepteur, constituée par une bascule de type D commandée en cadence, peut être appliqué un niveau logique ECL servant de tension d'exploration.

17. Equipement de test suivant la revendication 15, caractérisé par le fait que les émetteurs des quatorzième et quinzième transistors (T12, T13) sont reliés à la seconde borne (VCC) par l'intermédiaire d'une neuvième résistance ohmique (R19), d'une onzième et d'une douzième diodes Zener (D8, D9) et d'une dixième résistance ohmique (R15).

18. Equipement de test suivant la revendication 17, caractérisé par le fait qu'un seizième transistor (T6), dont la base est reliée à la prise d'un second diviseur de tension (R16, R17), est monté en parallèle sur les éléments dans le circuit d'émetteur commun du quatorzième et du quinzième transistors (T12, T13).

19. Equipement de test suivant la revendication 18, caractérisé par le fait que dans le circuit de collecteur du quatrième transistor (T8) se trouve le circuit de collecteur-émetteur d'un dix-septième transistor (T4) qui est conducteur en fonctionnement normal et dont la base est reliée à la masse par l'intermédiaire du second diviseur de tension (R16, R17), qu'entre la prise du second diviseur de

13

tension (R16, R17) et la seconde borne (VCC) se trouve le circuit de collecteur-émetteur d'un dix-huitième transistor (T5) dont la base est reliée au point de jonction de la dixième résistence ohmique (R15) avec la onzième diode Zener (D8).

20. Equipement de test suivant la revendication 19, caractérisé par le fait qu'une onzième résistance ohmique (R12) est montée entre le collecteur du quatrième transistor (T8) de l'état final (ES) et le collecteur du dix-septième transistor (T4).

21. Equipement de test suivant la revendication 20, caractérisé par le fait qu'entre la onzième résistance ohmique (R12) et le collecteur du dix-septième transistor (T4) se trouve le circuit de collecteurémetteur d'un dix-neuvième transistor (T9) dont la base est commandée par l'intermédiaire d'une treizième diode Zener (D7) et l'émetteur d'un vingtième transistor (T22), et dont la base forme une quatrième entrée de programmation (HI-P) à laquelle peut également être appliqué un signal logique TTL.

14

## FIG 1

FIG 2

0 032 222